(19) Europäisches Patentamt
European Patent Office
Office européen des brevets

(11) **EP 2 700 109 B1**

(12) **EUROPEAN PATENT SPECIFICATION**

(45) Date of publication and mention
of the grant of the patent:
**20.01.2016 Bulletin 2016/03**

(21) Application number: **12730626.4**

(22) Date of filing: **17.04.2012**

(51) Int Cl.:
**H01L 35/32** *(2006.01)*

(86) International application number:
**PCT/IB2012/051928**

(87) International publication number:
**WO 2012/143859 (26.10.2012 Gazette 2012/43)**

(54) **DEVICE FOR GENERATING ELECTRICAL ENERGY FROM HEAT SOURCES**

VORRICHTUNG ZUR ERZEUGUNG VON ELEKTRISCHER ENERGIE AUS WÄRMEQUELLEN

DISPOSITIF DE PRODUCTION D'ÉNERGIE ÉLECTRIQUE À PARTIR DE SOURCES DE CHALEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **19.04.2011 IT RM20110196**

(43) Date of publication of application:
**26.02.2014 Bulletin 2014/09**

(73) Proprietors:
• **Gerardino, Annamaria**
  **00187 Rome (IT)**
• **Lelio, Luca**
  **00187 Rome (IT)**

(72) Inventors:
• **Gerardino, Annamaria**
  **00187 Rome (IT)**
• **Lelio, Luca**
  **00187 Rome (IT)**

(74) Representative: **Scilletta, Andrea**
  **IP Sextant s.r.l.**
  **Via Antonio Salandra, 18**
  **00187 Roma (IT)**

(56) References cited:
**WO-A2-2005/114748     US-A1- 2005 247 337
US-B1- 6 403 876**

## Description

The invention relates a device for generating electrical energy, from heat sources, preferably renewable sources, such as for instance solar radiation, or even from systems having at least one temperature gradient, that allows in a simple, reliable and inexpensive way to obtain an effective conversion of thermal energy into electrical energy. In particular, the device allows to obtain a conversion of thermal energy into electrical energy through the Seebeck effect, increasing the conversion efficiency by means of the synergistic use of introducing plasmonic optics.

The present invention also relates to processes for manufacturing such device, and to the electrical energy generating systems including a plurality of such devices.

It is known that in the last decades many systems for generating electrical and thermal energy exploiting solar radiation have been developed. In particular, the generation of electrical energy is based on the photovoltaic effect the industrial application of which uses photovoltaic panels. Each of these is constituted by strings of single photovoltaic cells connected in series to each other.

The generation system by means of photovoltaic effect is the subject of continuous studies and researches in order to obtain an ever increasing number of cells per panel and/or cells the efficiency per unit area and per unit of received solar energy of which is as high as possible. This allow to significantly reduce the surface necessary for converting a fixed amount of incident solar energy into electrical energy, i.e. the miniaturisation of the cells allows to obtain a higher electrical energy in the same surface area. In other words, a wide research activity is carried out in order to increase the conversion efficiency from solar energy to electrical energy.

Recently, in this context, the properties of the so called surface plasmons have been studied. As initially described by Ritchie R. H. in "Plasma Losses by Fast Electrons in Thin Films", Physical Review, June 1957, Vol. 106, Issue 5, pp. 874-881, surface plasmons, or SPs, are waves propagating along a conductor surface, usually a metal. They are essentially light waves trapped on the surface due to their interaction with the free electrons on the conductor surface. In this interaction, the free electrons collectively answer oscillating in resonance with the light waves. The resonant interaction between the surface charge oscillations and the light electromagnetic field gives rise to the SPs.

One of the most interesting properties in the field of optics is the possibility of concentrating and channelling the electromagnetic radiation using structures with dimensions lower than the wavelength of the electromagnetic radiation to concentrate. In the case of photovoltaic energy generation systems, such electromagnetic radiation comprises visible and infrared wavelengths.

One of the key developments of photonics during the last 15 years has been based on the materials showing a photonic band gap. These are artificial materials in which periodic structures are used with dimensions of the order of the wavelength of interest for manipulating the interaction between radiation and matter and making new photonic structures (cavities, waveguides, filters, etc.). These devices are made in insulating or semiconducting materials (the so called photonic crystals).

Recently, some photovoltaic cells have been developed in which absorption of the incident solar radiation is enhanced by the presence of plasmonic structures, as proposed for example in documents EP1180802A2, WO2005114748A2, WO2008012516A2, WO2010123735A1 and US 2005/0247337.

However, the efficiency of conversion of the incident solar energy into electrical energy is still not very high, and almost the totality of these solutions entails a complexity of the cell structure and consequent high manufacturing costs.

It is therefore an object of the present invention to allow in a simple, effective, reliable, safe, and inexpensive way in a simple, reliable and inexpensive way to obtain a high efficiency of conversion of solar energy into electrical energy.

It is still an object of the present invention to allow an application of the proposed solution to the problem also to different energy sources.

It is specific subject matter of this invention a device for generating electrical energy, comprising at least one cell including supporting base means, characterised in that said at least one cell further comprises a first number N of first segments made of a first material having a first Seebeck coefficient, and a second number M of second segments made of a second material having a second Seebeck coefficient, where $M \geq 1$ and $N = M+1$, the first segments and the second segments being supported by said supporting base means and being electrically connected alternately in series, whereby M first junctions, between a first segment and a second segment, and M second junctions, between a second segment and a first segment, are alternately formed on said supporting base means, the first material and the second material being selected from the group of materials comprising electrically conductive materials and electrically semiconductor materials, each one of said M second junctions having a surface nanostructure having one or more portions of periodic nanostructure each one of which has a respective period ranging from 350 nanometers to 150 micrometers.

Always according to the invention, each one of said one or more portions of periodic nanostructure may comprise an array of shaped elements, whereby the distance among said shaped elements is the period of the respective periodic nanostructure, said shaped elements being preferably selected from the group comprising protruding hemispheres, hemispherical recesses, protruding rectangles (also called nanowires), rectangular recesses, protruding triangles, triangular recesses, protruding facing triangles (also called bow-ties), facing triangular recesses, protruding crosses, cross-shaped recesses, protruding circles, and circular recesses.

Still according to the invention, said at least one cell may comprise two contact end pads, at the ends of the alternate series connection of said N first segments and of said M second segments, whereby said at least one cell is electrically connectable in series to at least one further identical cell.

Furthermore according to the invention, said M second junctions may be capable to be exposed to solar radiation and said M first junctions may be covered by covering means, whereby said M first junctions are not exposable to solar radiation.

Always according to the invention, said supporting base means may comprise, at least in correspondence with said M second junctions, a coating of material that is anti-reflective to radiation having wavelength ranging from 700 nanometers to 300 micrometers.

Still according to the invention, said supporting base means may comprise, at least in correspondence with said M first junctions, one or more first cooling microfluidic circuits.

Furthermore according to the invention, said supporting base means may comprise a substrate made of semiconductor material, preferably silicon, on which a layer is present that comprises one or more first areas which are thermally conductive, preferably thermally conductive strips, each one of which supports at least one portion of said M first junctions, and one or more second areas which are thermally insulating, preferably thermally insulating strips, each one of which supports at least one portion of said M second junctions, said one or more thermally conductive first areas being made of a first material having a thermal conductivity preferably not lower than 100 W/m°K, more preferably not lower than 120 W/m°K, still more preferably not lower than 150 W/m°K, even more preferably not lower than 200 W/m°K, said one or more thermally insulating second areas being made of a second material having a thermal conductivity preferably not larger than 10 W/m°K, more preferably not larger than 1 W/m°K, still more preferably not larger than 0,1 W/m°K, even more preferably not larger than 0,05 W/m°K, said first material preferably comprising aluminium nitride and/or silicon carbide, said second material preferably comprising polyurethane foams and/or fibreglasses.

Always according to the invention, said covering means may comprise one or more thermally insulating protecting layers located on said M first junctions, said one or more thermally insulating protecting layers being preferably made of said second material.

Still according to the invention, said supporting base means comprises a flexible sheet of plastic material, preferably selected from the group comprising polyvinyl chloride (PVC), polyethylene terephthalate (PET), polycarbonate (PC), and polymethyl methacrylate (PMMA), wrapped around an even number of microtubes, each one having at least one planar supporting surface, said microtubes being alternately arranged in a first configuration, wherein said at least one planar supporting surface is directed towards a first surface of said at least one cell, and in a second configuration, wherein said at least one planar supporting surface is directed towards a second surface of said at least one cell, each microtube arranged according to said first configuration supporting the flexible sheet in correspondence with at least one of said M first junctions, each microtube arranged according to said second configuration supporting the flexible sheet in correspondence with at least one of said M second junctions, said second surface of said at least one cell being capable to be exposed to solar radiation, preferably said first surface of said at least one cell being not exposable to solar radiation when said second surface of said at least one cell is exposed to solar radiation, said microtubes preferably having a triangular section, the device preferably comprising in correspondence with said first surface of said at least one cell one or more second cooling microfluidic circuits.

Furthermore according to the invention, said supporting base means may comprise a plurality of shaped supports of rigid material, preferably selected from the group comprising silicon and plastic materials, more preferably from the group comprising PVC, PET, PC, and PMMA, each shaped support having an upper horizontal planar element and a lower horizontal planar element connected to a vertical planar element, said upper horizontal planar element supporting at least one of said M second junctions, said lower horizontal planar element supporting at least one of said M first junctions, the shaped supports being overlappable each other so that said upper horizontal planar elements overlap the lower horizontal planar elements, whereby said plurality of shaped supports form a planar structure having an upper surface capable to be exposed to solar radiation on which only said M second junctions are, said supporting base means further comprising at least one supporting plate provided with terminals for electrical series connection between adjacent overlapped shaped supports, said shaped supports being preferably provided with coupling mechanical means for coupling to adjacent shaped supports.

Always according to the invention, said supporting base means may comprise a plurality of base elements each one comprising a flexible sheet of plastic material, preferably selected from the group comprising PVC, PET, PC, and PMMA, that supports at least one of said M first junctions and at least one of said M second junctions, the flexible sheet being provided below said at least one second junction with a thermally insulating support, the support being shaped so that said plurality of base elements are overlapped each other for forming a planar structure having an upper surface capable to be exposed to solar radiation on which only said M second junctions are, said supporting base means further comprising at least one supporting sheet provided with terminals for electrical series connection between adjacent overlapped base elements, the thermally insulating support being made of a material having a thermal conductivity preferably not larger than 10 W/m°K, more preferably not larger than 1 W/m°K, still more preferably not larger than 0,1 W/m°K, even more preferably not larger than 0,05 W/m°K, said second material preferably comprising polyurethane foams and/or fibreglasses, a first sheet of Ethylene Vinyl Acetate (EVA) being preferably rolled on said plurality of overlapped base elements and a second sheet of EVA being preferably rolled below said at least one supporting sheet.

Still according to the invention, said supporting base means may comprise a strip of flexible polymeric material, and each one of said M first junctions may have a surface nanostructure having one or more portions of periodic nanostructure each one of which has a respective period ranging from 350 nanometers to 150 micrometers, preferably identical to the period of a corresponding portion of periodic nanostructure of the surface nanostructures of said M second junctions.

It is still specific subject matter of this invention a process for manufacturing a device for generating electrical energy as previously described, characterised in that it comprises the following steps:

A. having a flexible sheet of plastic material that supports a first number N of first segments made of a first material having a first Seebeck coefficient, and a second number M of second segments made of a second material having a second Seebeck coefficient, where M ≥ 1 and N = M+1, the first segments and the second segments being electrically connected alternately in series, whereby M first junctions, between a first segment and a second segment, and M second junctions, between a second segment and a first segment, are alternately formed on a first surface of the flexible sheet;

B. fastening a first end of the flexible sheet to a fastening element so as to have said first surface of the flexible sheet orientated towards a first direction;

C. moving a second end of the flexible sheet towards said first direction;

D. placing a first microtube, having at least one planar supporting surface, so as to orientate the planar supporting surface towards said first direction and to push the first microtube against a second surface of the flexible sheet opposed to the first surface;

E. moving said second end of the flexible sheet towards a second direction opposed to said first direction, so that at least one of said M second junctions is supported by the planar supporting surface of the first microtube;

F. placing a second microtube, having at least one planar supporting surface, so as to orientate the planar supporting surface towards said second direction and to push the second microtube against said first surface of the flexible sheet;

G. moving said second end of the flexible sheet towards said first direction, so that at least one of said M first junctions is supported by the planar supporting surface of the second microtube;

the process preferably repeating steps from D to G with further microtubes, each one having at least one planar supporting surface, until at least one of said M second junctions or at least one of said M first junctions is supportable by the planar supporting surface of a further microtube, the process being more preferably executed by a machine comprising a fastening element, capable to fasten said first end of the flexible sheet, and a moving element, capable to move said second end of the flexible sheet, a machine control unit being capable to control an operation of the fastening element and of the moving element.

The device for generating electrical energy according to the invention is based on the Seebeck effect for generating electrical energy, the efficiency of which is enhanced by the synergistic use of plasmonic optics.

In particular, the device may convert thermal energy absorbed from solar radiation that is concentrated through plasmonic optics.

The present invention will be now described, by way of illustration and not by way of limitation, according to its preferred embodiments, by particularly referring to the Figures of the enclosed drawings, in which:

Figure 1 schematically shows an electrical energy generator based on the Seebeck effect;
Figure 2 shows a perspective view (Fig. 2a) and a magnification of a particular of Figure 2a (Fig. 2b) of a cell of a first embodiment of the device according to the invention;
Figure 3 shows a prospective view of a cell of a second embodiment of the device according to the invention;
Figure 4 shows a front view (Fig.4a) and a top plan view (Fig. 4b) of a third embodiment of the device according to the invention;
Figure 5 schematically shows a first step (Fig. 5a), a second step (Fig. 5b), a third step (Fig. 5c), a fourth step (Fig. 5d), fifth step (Fig. 5e), a sixth step (Fig. 5f), a seventh step (Fig. 5g) of a preferred embodiment of the process for manufacturing the device of Fig. 4 according to the invention;
Figure 6 shows a perspective view of a cell (Fig. 6a), a front view (Fig. 6b), a top plan view (Fig. 6c), a partially exploded perspective view (Fig. 6d), a plan view of a first component (Fig. 6f), and a partial perspective view of the first component (Fig. 6g) of a fourth embodiment of the device according to the invention;
Figure 7 shows a perspective view of cell (Fig. 7a), a front view (fig. 7b), a front view of a further version (Fig. 7c), a magnified perspective view of a particular of the cell of Figure 7a (Fig. 7d), a perspective view of a possible application (Fig. 7e), a top plan view (Fig. 7f) and a front view (Fig. 7g) of a particular of the application of Figure 7e of a fifth embodiment of the device according to the invention;

Figure 8 shows a perspective view (Fig. 8a), a magnification of a particular of Figure 8a (Fig. 8b), a front view of an application (Fig. 8c) and a perspective view of a particular of the application of Figure 8c (Fig. 8d) of a sixth embodiment of the device according to the invention; and

Figure 9 shows a scheme (Fig. 9a), including a front view of the device of Figure 8, of a second application and a side view of a third application (Fig. 9b) of the device of Figure 8.

In the following description same reference numbers will be used for indicating alike elements in the Figures.

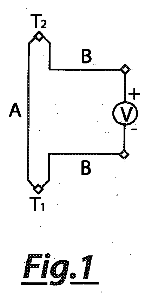

The inventors have faced the problem of obtaining a high efficiency of conversion of solar energy into electrical energy on the basis of the Seebeck effect, instead of the photovoltaic effect. As shown in Figure 1, in an electrical energy generator based on the Seebeck effect, a temperature difference $\Delta T=(T_2 - T_1)$ is applied to two junctions 1 and 2 of two different materials A and B, constituted by metals or semiconductors, having respective differing Seebeck coefficients (also said thermoelectric powers) $S_A$ e $S_B$. Due to such temperature difference $\Delta T$ between the junctions 1 and 2 a voltage V exists between the same junctions equal to:

$$ V = \int_{T_1}^{T_2} \left( S_B(T) - S_A(T) \right) \, dT $$

where $T_1$ is the temperature of the cold junction 1 and $T_2$ is the temperature of the hot junction 2 (i.e., $T_1 < T_2$). In particular, the Seebeck coefficients $S_A$ and $S_B$ are not linear and depend on the materials, on their absolute temperature and on their molecular structure.

Moreover, the inventors have also studied the activity and distribution of the SPs on metal surfaces, wherein metals are employed as materials with photonic band gap with reference to SPs, with reference to photonic surfaces. In particular, as described by Barnes W.L. et al. in "Surface Plasmon Subwavelength Optics", Nature: Insight Review Articles, August 14, 2003, pp. 824-830, vol. 424, Nature Publishing Group, when SPs propagate in a metal surface having a periodic structure on the scale of the light wavelength, their nature changes. If the period of the structure is half the effective wavelength of the SP mode, SP scattering may induce the formation of SP standing waves and the opening of a band gap for the SPs. If the modulation occurs along both plane axes (for example through an array of hemispheres) the SP modes cannot propagate in any direction along the plane, thus leading to a full band gap.

By making the periodic nanostructure so that the wavelength of interest, i.e. the infrared one (having wavelength ranging from 700 nanometers to 300 micrometers), is at the edge of a band gap, the density of the modes associated with the SPs is very high (i.e. the SP mode dispersion is flat) thus determining a very high concentration of the electromagnetic field close to the metal surface. Also, the inventors have developed the electrical energy generating device on the basis of the selectivity of this phenomenon with respect to the wavelength of the incident solar radiation independently from the angle of incidence of the same radiation, rendering the metal surface intrinsically frequency-selective.

The inventors have further verified that the flat dispersion bands are also associated with the localisation of the SP modes due to the presence of metal nanoparticles. The frequency and width of these modes are determined by the particle shape, material, size and interaction with the surrounding materials. In particular, the plasmonic interaction between two or more particles (i.e. the cooperative interaction between the effect of a plasmon with a particle and the effect of the same plasmon with one or more other particles) may lead to very high levels of electromagnetic field enhancement and to a better coupling between the incident radiation and the underlying structure, that in the device according to the invention based on the Seebeck effect is a so called hot junction between two materials, in order to improve the absorption of the same radiation.

In this way, the inventors have developed the device according to the invention wherein areas are made on the surface of a metal in which it is possible to concentrate the electromagnetic field of a wavelength defined in analogy to a resonant optical cavity, in order to induce a very high local heating in correspondence with a junction between two metals with appropriate Seebeck coefficients and to determine a high temperature difference with respect to a so-called cold junction and to raise the efficiency in the production of electrical energy through Seebeck effect. The inclusion of plasmonic resonant structures in the device according to the invention also determines a confinement of the infrared radiation by limiting the propagation of heat from the hot junction to the circuit. In fact, the plasmonic structures of the device according to the invention prevent the transmission of infrared waves along the metal outside the hot junction, making infrared mirrors capable to confine the infrared radiation in the area of the hot junction and to prevent propagation outside the same.

Given the frequency selectivity of the plasmonic nanostructures, linked to their period, the nanostructures of the device according to the invention preferably comprise a plurality of portions each having a different periodicity (e.g. by some percentage units) with respect to the others in order to cover the entire spectrum of interest of the infrared radiation of which the absorption in the area of the hot junction has to be enhanced. However, it should be understood that the nanostructure can comprise any number of portions, including one single portion having a specific periodicity (which, in this case, selects only one radiation frequency).

In the following, it is initially illustrated the manufacturing of a single component generator or cell of a device for generating electrical energy according to the invention. Each cell is provided with periodic nanostructures which constitute the plasmonic optics of the device. A plurality of cells can be connected in series to increase the generated electric power, in analogy to what currently occurs in photovoltaic panels.

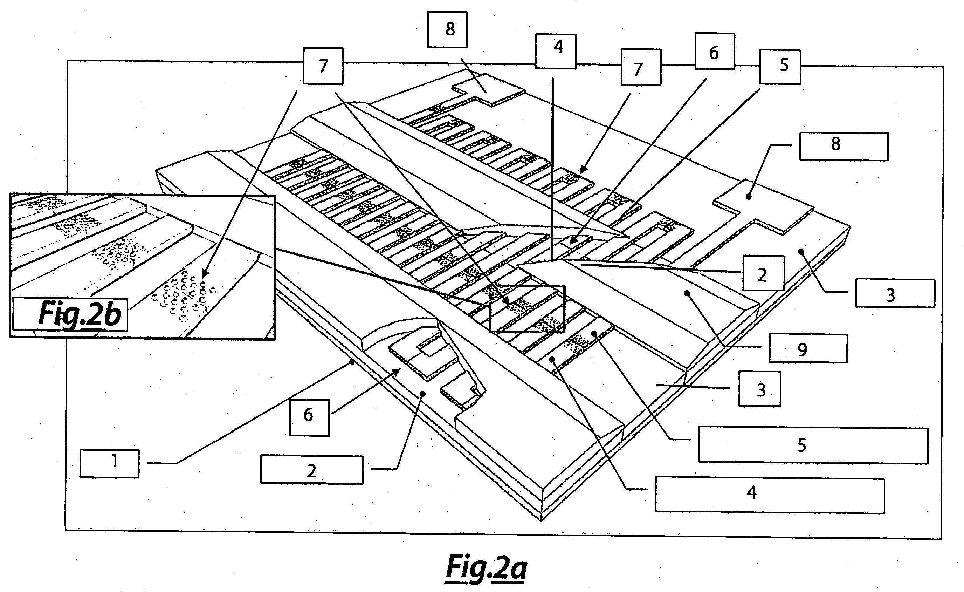

With reference to Figure 2a, it may be observed that a first embodiment of the device according to the invention includes a cell that comprises a substrate 1, made of a material that is typical of micromachining processes (e.g. silicon), on which a layer is present comprising, alternately, two first thermally conductive strips 2, made of a first material having a high thermal conductivity, adjacent to two second thermally insulating strips 3, made of a second material having a low thermal conductivity. In particular, the first strips 2 are in correspondence with the areas on which a plurality of cold junctions will be made, while the second strips 3 are in correspondence with the areas on which a plurality of hot junctions will be made. The first material, of which the first strips 2 are made, preferably has a thermal conductivity not lower than 100 W/m°K, more preferably not lower than 120 W/m°K, still more preferably not lower than 150 W/m°K, even more preferably not lower than 200 W/m°K; by way of example, and not by way of limitation, the first material may comprise aluminum nitride and/or silicon carbide, the values of thermal conductivity of which range between 120 and 180 W/m°K. The second material, of which the second strips 3 are made, preferably has a thermal conductivity not larger than 10 W/m°K, more preferably not larger than 1W/m°K, still more preferably not larger than 0,1 W/m°K, even more preferably not larger than 0.05 W/m°K; by way of example, and not by way of limitation, the second material may comprise polyurethane foams and/or glass fibres, the values of thermal conductivity of which range between 0.02 and 0.04 W/m°K.

On the layer overlapped to the substrate 1, a plurality of alternating segments are present, arranged according to a series connection, made of two electrically conducting or semiconducting materials respectively having a first and a second Seebeck coefficients, different from each other; in Figure 2a, the segments made of the material having the first Seebeck coefficient are indicated with the reference number 4, while the segments made of the material having the second Seebeck coefficient are indicated with the reference number 5. The series arrangement is such that the junctions between segments 4 and 5 are exclusively positioned on the first thermally conductive strips 2, where they are indicated with the reference number 6, and on the second thermally insulating strips 3, where they are indicated with the reference number 7; the junctions 6 will be hereafter also called as cold junctions 6, while the junctions 7 will be hereafter also called as hot junctions 7. The series connection between the plurality of alternating segments 4 and 5 ends with two contact pads 8.

The hot junctions 7 have a periodic surface nanostructure, shown in particular in the magnification of Figure 2b, which extends on both facing portions of the segments 4 and 5 of materials with different Seebeck coefficient. This nanostructure includes a plurality of shaped elements arranged as a matrix (also known as array), wherein the elements can be shaped, for example, as protruding hemispheres and/or semi-spherical recesses and/or protruding rectangles (also called nanowires) and/or rectangular recesses and/or protruding triangles and/or triangular recesses and/or protruding facing triangles (also called bow-tie) and/or facing triangular recesses and/or protruding crosses and/or cross-shaped recesses and/or protruding circles and/or circular recesses. The nanostructure of the hot junctions 7 comprises one or more portions each one of which has a period (i.e. the distance between the shaped elements) equal to half the wavelength of the mode of PSs of which it is desired to form standing waves, i.e. the infrared one (having a wavelength ranging from 700 nanometers to 300 micrometers).

The cold junctions 6 are coated with a thermally insulating protective layer 9 (which in Figure 2a is partially removed to make the underlying cold junctions 6 visible), e.g. made of the same material of which the thermally insulating strips 3 are made of. Preferably, the protective layer 9 is made as a strip of width equal to the width of the thermally conductive strip 2 on which the cold junctions 6 are.

Once the cell of Figure 2a of the device according to the invention is exposed to solar radiation, the hot junctions 7 are directly exposed to solar radiation and the nanostructures with which they are provided cause the concentration of the incident radiation, and the underlying thermally insulation strip 3 oppose to the removal of heat from the same hot junctions 7. Differently, the cold junctions 6 are protected by the protective layer 9 and the heat which accumulates there, in an already lower amount than that which accumulates in the hot junctions 7, is removed by the underlying thermally conductive strip 2. Consequently, the temperature of the hot junctions 7 increases rapidly and is kept much higher than that of the cold junctions 6, generating a voltage between each consecutive pair of junctions due to the Seebeck effect that leads to an overall significant voltage between the two end pad 8. Obviously, the role of hot and cold junctions of Figure 2a can be easily reversed, with the necessary adaptations and/or displacements of the respective strips 2 and 3 and of the protective layers 9.

It is clear that, in order to make pairs of junctions capable to generate a voltage due to the Seebeck effect, the cell of the device preferably comprises a first number N of segments 4 and a second number M of segments 5, where M ≥ 1 and N = M+1, whereby there are M cold junctions 6, between a segment 4 and a segment 5, and M hot junctions 7, between a segment 5 and a segment 4.

In particular, as it will be shown below by way of example, it is possible to connect in series a plurality of cells similar to that shown in Figure 2a.

Other embodiments of the device according to the invention may include a different number of first thermally conductive strips 2 and of second thermally insulating strips 3, e.g. a single thermally conductive strip and a single thermally insulating strip or three or more thermally conductive strips and three or more thermally insulating strips, on each one of which any number, equal to or larger than one, of cold or hot junctions, respectively 6 or 7, is pre-sent. Further embodiments of the device according to the invention may have first thermally conductive areas and second thermally insulating areas having shape different from the strips and arranged so as to support, respectively, cold junctions and hot junctions having a configuration different from that of Figure 2a.

In addition, other embodiments of the device according to the invention can have the singles cells, such as that shown in Figure 2a, in which the second thermally insulating strips 3 are provided with a coating of an anti-reflective material the region of the infrared radiation in order to further increase the absorption of the incident radiation by the hot junctions 7. In this regard, the coating of anti-reflective material could also cover the first thermally conductive strips 2, since the protective layer 9 prevents the solar radiation to reach such a coating in correspondence with the cold junctions 6.

Finally, the individual cells, such as that shown in Figure 2a, may also be provided with a transparent protective coating.

The realization of the cell of Figure 2a can be carried out by using several manufacturing techniques. In particular, the first and second strips 2 and 3 may be made by selective deposition according to the electronic micromachining techniques (e.g. optical lithography, subsequent deposition of material and lift-off) or screen printing.

For manufacturing the periodic surface nanostructures (i.e. the plasmonic optics) of the hot junctions 7 it may be advantageous to make corresponding surface nanostructures on the substrate 1 or on the thermally insulating strips 3, in such a way that the successive selective depositions on such nanostructures produce corresponding nanostructures on the upper surface of the hot junctions 7.

In particular, for manufacturing the periodic surface nanostructures of the hot junctions 7 it is advantageous to make molds or masks with resolutions up to hundreds of nanometers by means of electron beam lithography. Such molds or masks can then be replicated with cheaper lithographies, such as nanoimprint lithography or soft lithography or other optical lithography processes.

The deposition of the segments 4 and 5 in electrically conductive or semiconductor materials having different Seebeck coefficients may occur according to the thin film technologies (lithography, deposition and lift-off) or through the technologies of "printed" electronics, such as for instance screen-printing or ink-jet printing, in a way similar to making contacts for the conventional photovoltaic cells.

In particular, the technologies of printed electronics allow making devices also on flexible and, for example, plastic supports, rendering integration of the cells, as that of Figure 2a, with other types of devices in an extremely versatile way possible. Some examples of such integration will be described below.

Also the aforementioned coating of anti-reflective material can be deposited through electronic micromachining techniques.

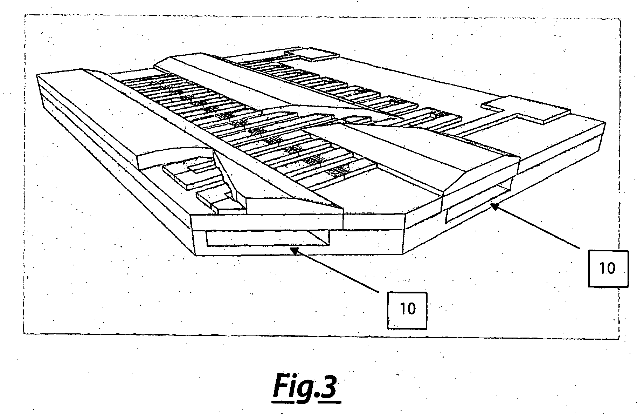

With reference to Figure 3, it can be observed that a second embodiment of the device according to the invention includes a cell wherein the substrate 1 is integrated with a microfluidic circuit, of which two conduits 10 are visible which are positioned under the first thermally conductive strips 2, for cooling the area of the cold junctions 6 by means of a fluid of conventional type (for example demineralised water or aqueous solutions of ethyl or isopropyl alcohol to overcome the problem of freezing). In other words, such a microfluidic circuit achieves a more efficient heat exchange; the determination of the size and shape of the microfluidic circuit is within the reach of the skilled in the art. In particular, the two conduits 10 shown in Figure 3 are made by means of two tanks obtained on the upper surface of the substrate 1 closed by the first thermally conductive strips 2. Also the microfluidic circuit can be made through of electronic micromachining techniques.

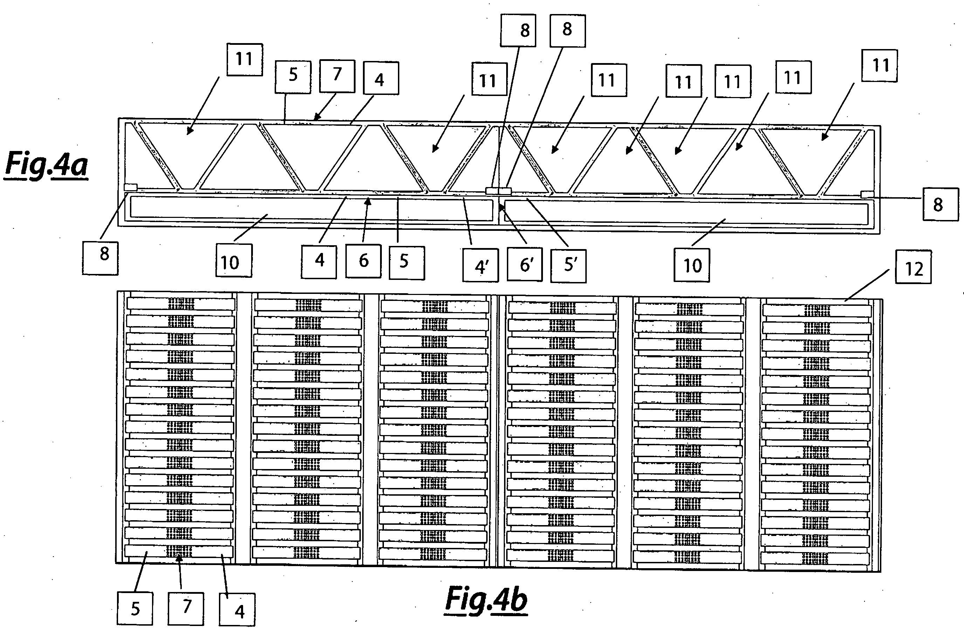

Figure 4 shows a third embodiment of the device according to the invention that includes two cells, in each one of which the deposition of the segments 4 and 5, made of electrically conductive or semiconductor materials having different Seebeck coefficients and connected in series, takes place in planar manner on a flexible sheet 12 of plastic material, preferably polyvinyl chloride (PVC) or polyethylene terephthalate (also known as PET) or polycarbonate (also known as PC) or polymethylmethacrylate (also known as PMMA) of appropriate dimensions. The flexible sheet 12 is then wound (as shown in Figure 4a) around microtubes 11 (in Figure 4a with a substantially triangular section) in an alternating way (i.e. in a zig-zag), so as to have all the hot junctions 7 in the upper part of the cell, which is exposed to solar radiation, and all the cold junctions 6 in the lower part of the cell. As in case of Figure 2, all the junctions of each cell of Figure 4 are connected in series to each other; in addition, at the ends of each single flexible sheet 12, thus assembled together with the microtubes 11, two end pads 8 are present which permit the prolongation of the series connection with other contiguous cells up to reaching the desired area. Each cell of Figure 4 actually comprises an odd number of junctions; also such embodiment of the device falls within the general definition given above, i.e. of a cell comprising N segments 4 and M segments 5, with N = M + 1, whereby there are M cold junctions 6 and M hot junctions 7; the cell of Figure 4 then comprises a further segment 5, whereby the connection with a contiguous cell takes place between a segment 4' of the first cell and a segment 5' of the second cell, such connection creating a further cold junction 6'.

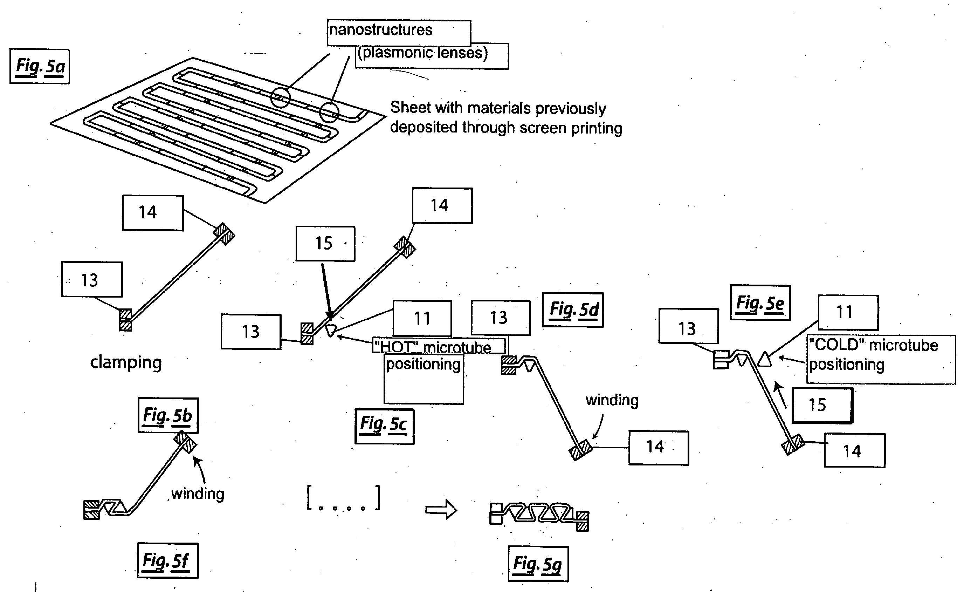

Figure 5 schematically shows the process of winding the flexible sheet 12 around the microtubes 11, executable by a simple machine as follows. In particular, Figure 5a shows the flexible sheet 12 on the upper surface of which the segments 4 and 5 are deposited, for example by screen printing. Figure 5b shows a first end of the sheet 12 that is fixed by a clamping element 13 so as to have the segments 4 and 5 oriented upwards, while a second end of the sheet is raised by a handling element 14. In particular, the machine is provided with a control unit capable to control the operation of the clamping element 13 and handling element 14. Subsequently, Figure 5c shows that the machine places a first microtube 11, having a triangular section (or in any case having at least one planar supporting surface), in such a way as to orientate a planar supporting surface 15 upwards and to push it against the lower surface of the flexible sheet 12. Subsequently, Figure 5d shows that the handling element 14 lowers the second end of the sheet 12, so that a first row of hot junctions 7 are supported by the planar surface 15 supporting the first microtube 11. Then, Figure 5e shows that the machine places a second microtube 11, having a triangular section (or in any case having at least one planar supporting surface), in such a way to orientate a planar supporting surface 15 downwards and to push it against the upper surface of the flexible sheet 12. Subsequently, Figure 5f shows that the handling element 14 raises the second end of the sheet 12, so that a first row of cold junctions 6 are supported by the planar surface 15 supporting the second microtube 11. The process carried out by the machine repeats the steps shown in Figures 5c, 5d, 5e and 5f until, as shown in Figure 5g, a cell of the device such as those shown in Figure 4 is obtained.

Advantageously, in order to make the nanostructures of the hot junctions 7, the flexible sheet 12 may be provided in the upper part with surface nanostructures in the areas where the hot junctions 7 will be made, in such a way that the subsequent selective depositions of materials with different Seebeck coefficients on such nanostructures sheet 12 produce the nanostructures of the hot junctions 7.

Similarly to what shown in figure 3, the lower surface of the cells of Figure 4 is provided with a microfluidic circuit, of which two conduits 10 are visible, for cooling the cold junctions 6 by means of a fluid.

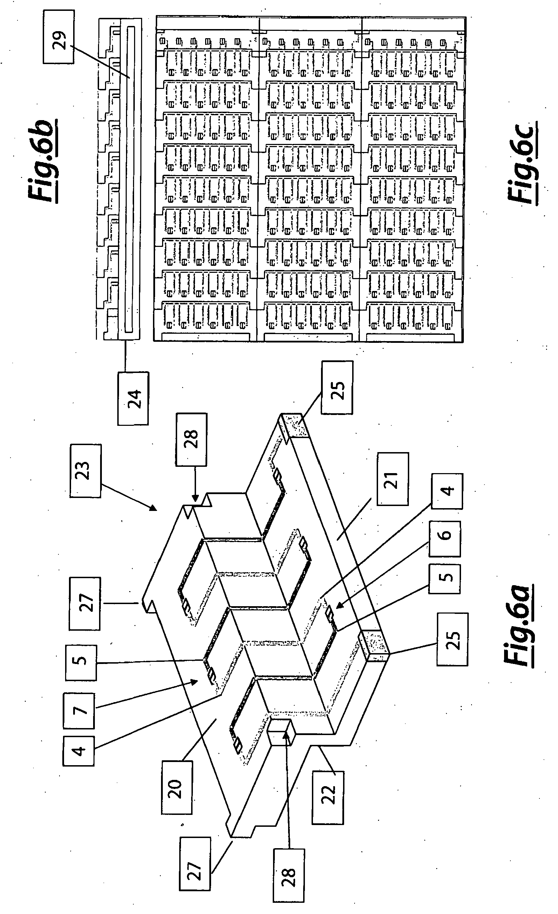

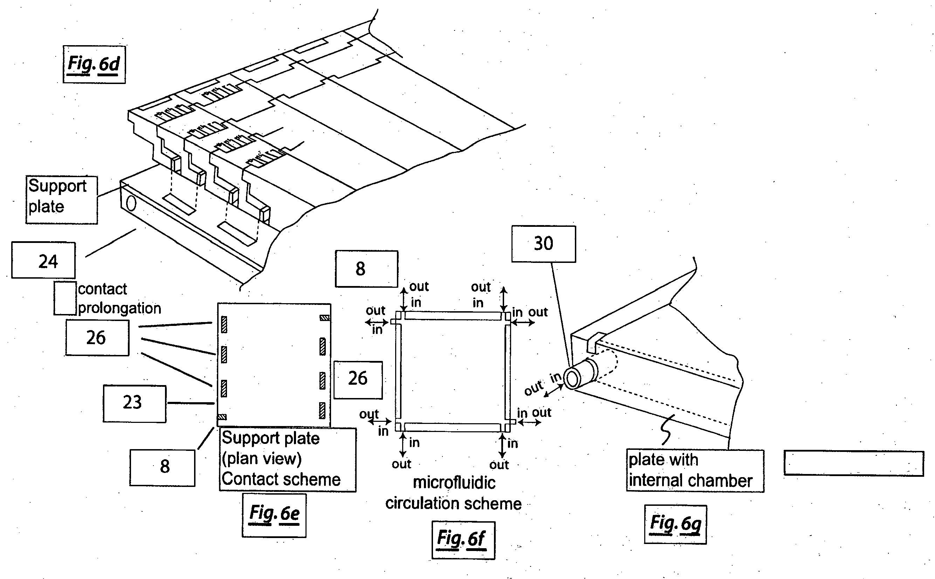

A fourth embodiment of the device according to the invention is shown in Figure 6, wherein the deposition of the segments 4 and 5, made of electrically conducting or semiconducting materials having different Seebeck coefficients, takes place on supports 23 of plastic material (e.g. PC or PVC or PET or PMMA) or silicon, overlappable each other so as to form a planar structure. In particular, each plastic support is shaped like a tile having a section similar to a Z, having two planar horizontal elements 20 and 21 at different heights (i.e., an upper horizontal planar element 20 and a lower horizontal planar element 21) connected by a vertical planar element 22. The hot junctions 7 are located on the upper surface 7 of the upper planar horizontal element 20 while the cold junctions 6 are located on the upper surface of the lower planar horizontal element 21. Similarly to what illustrated above, in order to make the nanostructures of the hot junctions 7, the upper surface of the upper planar horizontal element 20 may be advantageously provided in the upper part with surface nanostructures, in the areas where the hot junctions 7 will be made, in such a way that the subsequent selective depositions of materials with different Seebeck coefficients on such nanostructures produce the nanostructures 12 of the hot junctions 7.

The tile supports 23 can be juxtaposed and overlapped to each other, as shown in Figures 6b, 6c and 6d, in such a way that only the hot junctions 7 are exposed to solar radiation, while the cold junctions are covered by the upper planar horizontal element 20 of an adjacent support 23. In particular, the number of supports 23 connected in series can be increased as desired up to reaching the desired size for forming a cell. Each cell lies on a support plate 24 that contributes to the electrical series connection among the plurality of supports 23, offering two side terminals 8 (shown in Figure 6e) available for further connections with other cells up to reaching the desired coverage; in particular, the electrical series connection of a support 23 with the two adjacent side supports (i.e, not overlapped) is achieved by means of two side terminals 25 (shown in Figure 6a) present on the lower planar horizontal element 21 (other embodiments may have different positions of these two side terminals 25), while the electrical series connection of a support 23 with two adjacent supports with which it overlaps frontally and rearwardly is made by means of respective terminals 26 present on the plate 24.

The correct overlapping of the supports 23 to each other can be promoted by specific coupling mechanical means, such as for instance two projecting elements 27 (shown in Figure 6a) of the upper planar horizontal element 20 of a first support 23 capable to insert in two corresponding notches 28 (also shown in Figure 6a) of the upper planar horizontal element 20 of a second support 23 adjacent to the first one (to the lower planar horizontal element 21 of which second support 23 the upper planar horizontal element 20 of the first support overlaps).

The support plate 24 can be provided with a microfluidic circuit, comprising a chamber 29 (shown in Figures 6b, 6f and 6g) accessible from eight input/output ducts 30 (shown in Figures 6f and 6g), for cooling the cold junctions 6 by means of a fluid that achieves a more efficient heat exchange; the circulation of the fluid takes place through an inlet and an outlet, selected among the eight ducts 30, for each cell, so that it is possible to connect in series also hydraulically a plurality of cells. Also in this case it is possible to deposit on the part of the hot junctions an anti-reflective material for helping the absorption of infrared radiation; moreover, it is also possible to place under the hot junctions, and in contact with these, a layer of thermally insulating material and/or under the cold junctions, and in contact with these, a layer of thermally conductive material for dispersing heat.

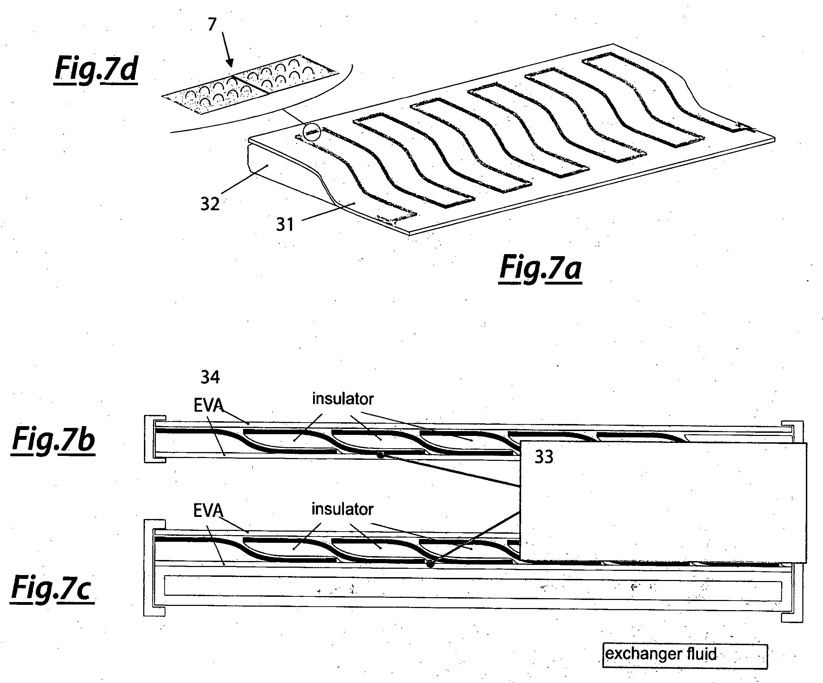

A fifth embodiment of the device according to the invention may have a configuration similar to that shown in Figure 6 wherein the support 23 is replaced by a flexible plastic sheet, such as PVC or PET or PC or PMMA, by using strips of plastic material partially overlapping so as to leave the hot junctions (provided with the plasmonic structures) exposed and inserting under the subsequent sheet the cold junctions. An example of this fifth embodiment of the device according to the invention comprises the base element shown in Figure 7a, where the sheet 31 is visible on which the hot junctions 7 (one of which is shown magnified in Figure 7d) are present, on a portion of the sheet 31 lying on a thermally insulating substrate 32, and the cold junctions 6. A single cell of the device, shown in Figure 7b, is made by connecting in series a plurality of base elements like the one shown in Figure 7a, lying on a sheet 33 which makes part of the electrical connection (similarly to the plate 24 of Figure 6).

As shown in Figure 7c, the lower surface of the cell may be provided with a microfluidic circuit for the cooling by means of a fluid that achieves a more efficient heat exchange; similarly to the cell of Figure 6, the microfluidic circuit includes a chamber 29 accessible from input/output ducts for allowing the hydraulic connection of a plurality of cells.

A possible application of the device, may be that wherein the base elements of Figure 7a are assembled in series in variable dimensions and then laminated in accordance with conventional techniques used in the manufacturing industry of the photovoltaic panels, in this case, on the plurality of base elements and under the electrical connection sheet 33 the cell comprises, respectively, two sheets 34 of Ethylene Vinyl Acetate (also known as EVA), as shown in Figures 7b and 7c.

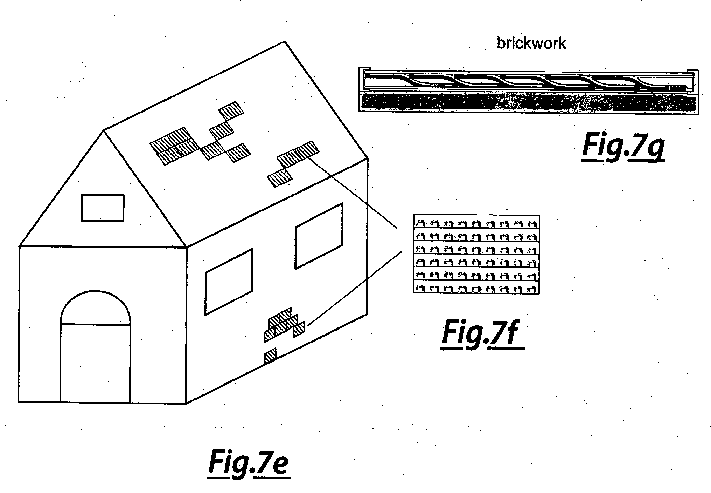

Since the device obtainable through the base elements and the cells of Figure 7 presents in various forms, it is suitable to be used as a coating material for construction, as schematically shown in Figures 7e, 7f and 7g.

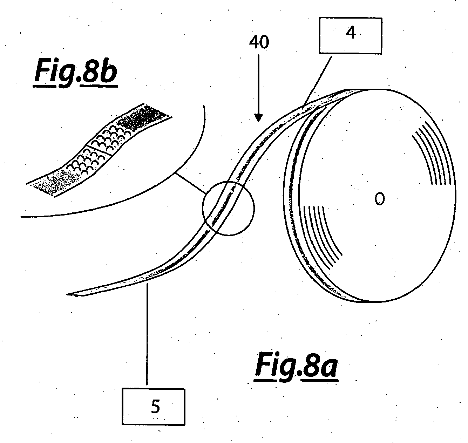

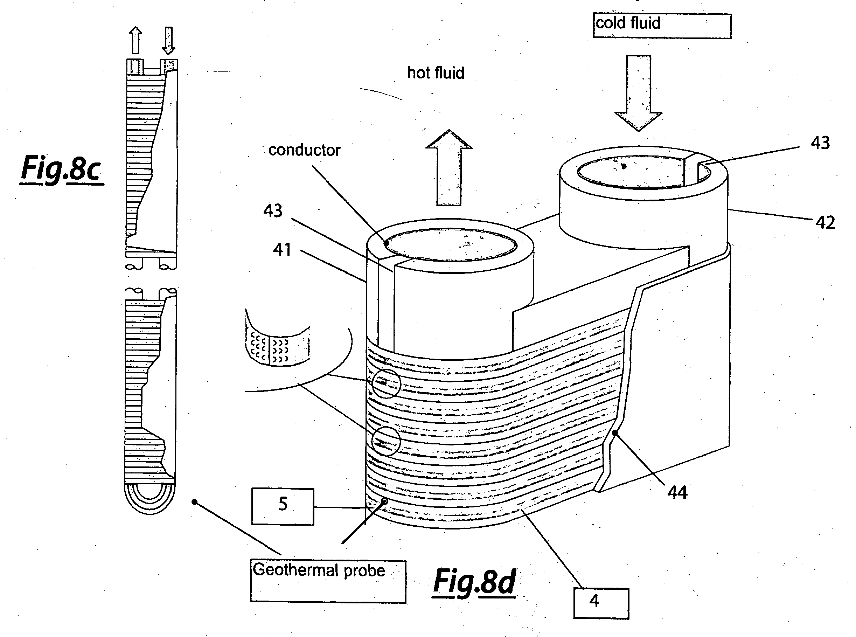

With reference to Figure 8, a sixth embodiment of the device according to the invention may be observed, capable to be applied to classical and/or low enthalpy geothermal plants. The device of Figure 8 comprises a strip 40 of flexible polymeric material provided with a plurality of nanostructures, on which segments 4 and 5 of electrically conductive or semiconducting materials having different Seebeck coefficients are alternately deposited, hereinafter referred to as " thermoelectric strip." It should be noted that in this case the realization of the nanostructures, i.e. the realization of the plasmonic optics, must take place on the whole extension of the thermoelectric strip 40 or at least on all the areas on which the junctions between the two materials are made, regardless of whether they are used as hot junctions or as cold junctions. In this case, when the junction acts as a cold junction, the nanostructure operates as an infrared mirror thus protecting the junction from the heat; when the junction acts as a hot junction the nanostructure concentrates the heat preventing it from moving away from the junction.

As shown in Figures 8c and 8d, the thermoelectric strip 40 is spirally wound on the delivery pipes 41 and return pipes 42 constituting a so-called geothermal probe inside of which the heat exchanger fluid (usually ethylene glycol) flows. In particular, the segments 4 and 5 may have predetermined lengths so that the distances between consecutive junctions correspond to standard values of geothermal probes. In the winter operation mode or in classical geothermal installations, the junctions operating as hot junctions of the strip are in contact with the return pipe 42, while the junctions operating as cold junctions are in contact with the delivery pipe 41 giving rise in this way to the Seebeck effect with consequent generation of electrical energy. For promoting a more efficient and high temperature difference, the delivery and return pipes forming the geothermal probe, which normally are made of polyethylene, are advantageously provided on a generatrix of a strip 43 of metal of suitable dimensions to facilitate the heat exchange with the junctions of the thermoelectric strip 40. When in the hot season the fluid flow in the geothermal probe is reversed for carrying out the cooling of rooms, it will be sufficient to reverse the polarities of the system collecting electrical energy for continuing to have generation of electrical energy. As a matter of fact, in winter operation mode (i.e. for heating the house) and in summer operation mode (for cooling the house) the junctions between segments 4 and 5 will alternate in operating as hot or cold junctions without any substantial difference, since what determines the generation of electrical energy is the temperature difference and the coupling of materials with different Seebeck coefficient, thanks to the fact that the plasmonic nanostructures are made in correspondence of all the junctions. The assembly can be advantageously thermally insulated and enclosed in a thermally insulating outer container 44 for maximising the difference in temperature. Since the temperature difference remains independently from season variation and independently from alternation of day and night, this system is capable of continuously generating electric energy to the contrary of what happens in traditional photovoltaic panels.

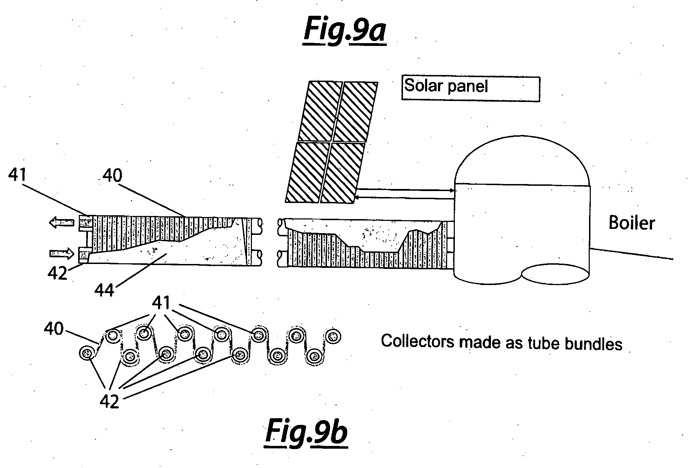

With reference to Figure 9, it can be observed a further application of the thormoelectric strip of Figure 8a to thermal solar plants. In this case, the thermoelectric strip is wound on delivery manifolds 41 and return manifolds 42 of the boiler 45 of the solar plant with the same procedure described for the geothermal probe of Figures 8c and 8d. To increase the number of junctions, the delivery and return manifolds 41 and 42 can be made not as single manifolds but as tube bundles, as shown in Figure 9b.

In general, the thermoelectric strip 40 can be used for the purposes of the present invention wherever there is a significant temperature gradient.

The preferred embodiments have been above described and some modifications of this invention have been suggested, but it should be understood that those skilled in the art can make variations and changes, without so departing from the related scope of protection, as defined by the following claims.

## Claims

1. Device for generating electrical energy, comprising at least one cell including supporting base means (1, 2, 3; 12; 23), said at least one cell further comprises a first number N of first segments (4) made of a first material having a first Seebeck coefficient, and a second number M of second segments (5) made of a second material having a second Seebeck coefficient, where $M \geq 1$ and $N = M+1$, the first segments (4) and the second segments (5) being supported by said supporting base means (1, 2, 3; 12; 23) and being electrically connected alternately in series, whereby M first junctions (6), between a first segment (4) and a second segment (5), and M second junctions (7), between a second segment (5) arid a first segment (4), are alternately formed on said supporting base means (1, 2, 3; 12; 23), the first material and the second material being selected from the group of materials comprising electrically conductive materials and electrically semiconducting materials, **characterised by** each one of said second junctions (7) having a surface nanostructure having one or more portions of a periodic nanostructure each one of which has a respective period ranging from 350 nanometers to 150 micrometers.

2. Device according to claim 1, **characterised in that** each one of said one or more portions of periodic nanostructure comprises an array of shaped elements, whereby the distance among said shaped elements is the period of the respective periodic nanostructure, said shaped elements being preferably selected from the group comprising protruding hemispheres, hemispherical recesses, protruding rectangles (also called nanowires), rectangular recesses, protruding triangles, triangular recesses, protruding facing triangles (also called bow-ties), facing triangular recesses, protruding crosses, cross-shaped recesses, protruding circles, and circular recesses.

3. Device according to claim 1 or 2, **characterised in that** said at least one cell comprises two contact end pads (8), at the ends of the alternate series connection of said N first segments (4) and of said M second segments (5), whereby said at least one cell is electrically connectable in series to at least one further identical cell.

4. Device according to any one of the preceding claims, **characterised in that** said M second junctions (7) are capable to be exposed to solar radiation and **in that** said M first junctions (6) are covered by covering means (9), whereby said M first junctions (6) are not exposable to solar radiation.

5. Device according to any one of the preceding claims, **characterised in that** said supporting base means (1, 2, 3; 12; 23) comprises, at least in correspondence with said M second junctions (7), a coating of material that is anti-reflective to radiation having wavelength ranging from 700 nanometers to 300 micrometers.

6. Device according to any one of the preceding claims, **characterised in that** said supporting base means (1, 2, 3; 12; 23) comprises, at least in correspondence with said M first junctions (6), one or more first cooling microfluidic circuits.

7. Device according to any one of the preceding claims, **characterised in that** said supporting base means (1, 2, 3; 12; 23) comprises a substrate (1) made of semiconductor material, preferably silicon, on which a layer is present that comprises one or more first areas (2) which are thermally conductive, preferably thermally conductive strips, each one of which supports at least one portion of said M first junctions (6), and one or more second areas (2) which are thermally insulating, preferably thermally insulating strips, each one of which supports at least one portion of said M second junctions (7), said one or more thermally conductive first areas (2) being made of a first material having a thermal conductivity preferably not lower than 100 W/m°K, more preferably not lower than 120 W/m°K, still more preferably not lower than 150 W/m°K, even more preferably not lower than 200 W/m°K, said one or more thermally insulating second areas (2) being made of a second material having a thermal conductivity preferably not larger than 10 W/m°K, more preferably not larger than 1 W/m°K, still more preferably not larger than 0,1 W/m°K, even more preferably not larger than 0,05 W/m°K, said first material preferably comprising aluminium nitride and/or silicon carbide, said second material preferably comprising polyurethane foams and/or fibreglasses.

8. Device according to claim 7, when depending on claim 4, **characterised in that** said covering means comprises one or more thermally insulating protecting layers (9) located on said M first junctions (6), said one or more thermally insulating protecting layers (9) being preferably made of said second material.

9. Device according to any one of the claims 1 to 6, **characterised in that** said supporting base means (1, 2, 3; 12; 23) comprises a flexible sheet (12) of plastic material, preferably selected from the group comprising polyvinyl chloride (PVC), polyethylene terephthalate (PET), polycarbonate (PC), and polymethyl methacrylate (PMMA), wrapped around an even number of microtubes (11), each one having at least one planar supporting surface (15), said microtubes (11) being alternately arranged in a first configuration, wherein said at least one planar supporting surface (15) is directed towards a first surface of said at least one cell, and in a second configuration, wherein said at least one planar supporting surface (15) is directed towards a second surface of said at least one cell, each microtube arranged according to said first configuration supporting the flexible sheet (12) in correspondence with at least one of said M first junctions (6), each microtube arranged according to said second configuration supporting the flexible sheet (12) in correspondence with at least one of said M second junctions (7), said second surface of said at least one cell being capable to be exposed to solar radiation, preferably said first surface of said at least one cell being not exposable to solar radiation when said second surface of said at least one cell is exposed to solar radiation, said microtubes (11) preferably having a triangular section, the device preferably comprising in correspondence with said first surface of said at least one cell one or more second cooling microfluidic circuits.

10. Device according to any one of the claims 1 to 6, **characterised in that** said supporting base means (1, 2, 3; 12; 23) comprises a plurality of shaped supports (23) of rigid material, preferably selected from the group comprising silicon and plastic materials, more preferably from the group comprising PVC, PET, PC, and PMMA, each shaped support (23) having an upper horizontal planar element (20) and a lower horizontal planar element (21) connected to a vertical planar element (22), said upper horizontal planar element (20) supporting at least one of said M second junctions (7), said lower horizontal planar element (21) supporting at least one of said M first junctions (6), the shaped supports (23) being overlappable each other so that said upper horizontal planar elements (20) overlap the lower horizontal planar elements (21), whereby said plurality of shaped supports (23) form a planar structure having an upper surface capable to be exposed to solar radiation on which only said M second junctions (7) are, said supporting base means (1, 2, 3; 12; 23) further comprising at least one supporting plate (24) provided with terminals (26) for electrical series connection between adjacent overlapped shaped supports (23), said shaped supports (23) being preferably provided with coupling mechanical means (27, 28) for coupling to adjacent shaped supports (23).

11. Device according to any one of the claims 1 to 6, **characterised in that** said supporting base means (1, 2, 3; 12; 23) comprises a plurality of base elements each one comprising a flexible sheet (31) of plastic material, preferably selected from the group comprising PVC, PET, PC, and PMMA, that supports at least one of said M first junctions (6) and at least one of said M second junctions (7), the flexible sheet (31) being provided below said at least one second junction (7) with a thermally insulating support (32), the support (32) being shaped so that said plurality of base elements are overlapped each other for forming a planar structure having an upper surface capable to be exposed to solar radiation on which only said M second junctions (7) are, said supporting base means (1, 2, 3; 12; 23) further comprising at least one supporting sheet (33) provided with terminals for electrical series connection between adjacent overlapped base elements, the thermally insulating support (32) being made of a material having a thermal conductivity preferably not larger than 10 W/m°K, more preferably not larger than 1 W/m°K, still more preferably not larger than 0,1 W/m°K, even more preferably not larger than 0,05 W/m°K, said second material preferably comprising polyurethane foams and/or fibreglasses, a first sheet of Ethylene Vinyl Acetate (EVA) being preferably rolled on said plurality of overlapped base elements and a second sheet of EVA being preferably rolled below said at least one supporting sheet (33).

12. Device according to any one of the claims 1 to 6, **characterised in that** said supporting base means (1, 2, 3; 12; 23) comprises a strip (40) of flexible polymeric material, and **in that** each one of said M first junctions (6) has a surface nanostructure having one or more portions of periodic nanostructure each one of which has a respective period ranging from 350 nanometers to 150 micrometers, preferably identical to the period of a corresponding portion of periodic nanostructure of the surface nanostructures of said M second junctions (7).

13. Process for manufacturing a device for generating electrical energy according to claim 9, **character-**

**ised in that** it comprises the following steps:

A. having a flexible sheet (12) of plastic material that supports a first number N of first segments (4) made of a first material having a first Seebeck coefficient, and a second number M of second segments (5) made of a second material having a second Seebeck coefficient, where M ≥ 1 and N = M+1, the first segments (4) and the second segments (5) being electrically connected alternately in series, whereby M first junctions (6), between a first segment (4) and a second segment (5), and M second junctions (7), between a second segment (5) and a first segment (4), are alternately formed on a first surface of the flexible sheet (12);

B. fastening a first end of the flexible sheet (12) to a fastening element (13) so as to have said first surface of the flexible sheet (12) orientated towards a first direction;

C. moving a second end of the flexible sheet (12) towards said first direction;

D. placing a first microtube (11), having at least one planar supporting surface (15), so as to orientate the planar supporting surface (15) towards said first direction and to push the first microtube (11) against a second surface of the flexible sheet (12) opposed to the first surface;

E. moving said second end of the flexible sheet (12) towards a second direction opposed to said first direction, so that at least one of said M second junctions (7) is supported by the planar supporting surface (15) of the first microtube (11);

F. placing a second microtube (11), having at least one planar supporting surface (15), so as to orientate the planar supporting surface (15) towards said second direction and to push the second microtube (11) against said first surface of the flexible sheet (12);

G. moving said second end of the flexible sheet (12) towards said first direction, so that at least one of said M first junctions (6) is supported by the planar supporting surface (15) of the second microtube (11);

the process preferably repeating steps from D to G with further microtubes (11), each one having at least one planar supporting surface (15), until at least one of said M second junctions (7) or at least one of said M first junctions (6) is supportable by the planar supporting surface (15) of further microtube (11), the process being more preferably executed by a machine comprising a fastening element (13), capable to fasten said first end of the flexible sheet (12), and a moving element (14), capable to move said second end of the flexible sheet (12), a machine control unit being capable to control an operation of the fastening element (13) and of the moving element (14).

**Patentansprüche**

1. Vorrichtung zur Erzeugung von elektrischer Energie, umfassend mindestens eine Zelle, die Mittel (1, 2, 3; 12; 23) des Grundgestells, dass die zumindest eine Zelle weiter gekennzeichnet eine erste Anzahl N von ersten Segmenten enthält (4) aus einem ersten Material mit einer ersten Seebeck-Koeffizienten, und eine zweite Anzahl M von zweiten Segmenten (5) aus einem zweiten Material mit einem zweiten Seebeck-Koeffizienten, wobei M ≥ 1 und N = M + 1, die hergestellt ist die ersten Segmente (4) und die zweiten Segmente (5) unterstützt, daß die Mittel (1, 2, 3; 12; 23) der Basisträger und die elektrisch in Reihe abwechselnd miteinander verbunden sind, für die M ersten Verbindungsstellen (6) zwischen einem ersten Segment (4) und einem zweiten Segment (5) und M zweiten Gelenken (7), der zwischen einem zweiten Segment (5) und ein erstes Segment (4), wechselweise auf der Oberseite der gebildeten Mittel (1, 2, 3; 12; 23) des Basisträgers, wobei das erste Material und das zweite Material aus der Gruppe von Materialien, die elektrisch leitenden Materialien und Halbleitermaterialien elektrisch ausgewählt, M zweiten Gelenke (7) mit einer Nanostruktur jedem Oberfläche mit einem oder mehreren Abschnitten des periodischen Nanostruktur, von denen jeder einen jeweiligen Zeitraum im Bereich von 350 Nanometer bis 150 Mikrometer.

2. Vorrichtung nach Anspruch 1, **dadurch gekennzeichnet, daß** jede der ein oder mehrere Abschnitte des periodischen Nanostruktur eine Matrix von Formelementen, wobei der Abstand zwischen dem Formkörper ist die Periode des entsprechenden periodischen Nanostruktur, die geformten Elemente vorzugsweise ausgewählt aus Gruppe, die Halbkugeln vorsteht, halbkugelförmigen Mulden, Rechtecke Jütting (auch Nanodrähte), rechteckigen Aussparungen, vorspringende dreiecke, dreieckigen Nuten, mit Blick auf Dreiecken (auch Fliege) hervorstehenden, dreieckigen Nuten zugewandt, Projektierung Kreuze, Querrillen, Projektierung Kreisen, und kreisförmigen Nuten.

3. Vorrichtung nach Anspruch 1 oder 2, **dadurch gekennzeichnet, daß** mindestens eine Zelle zwei Pads bzw. Anschlußterminals (8) Kontakt, die an den Enden der Reihenschaltung aus N alternierenden ersten Segmente (4) und der M zweiten Segmente (5) ist, wobei die mindestens eine Zelle ist elektrisch in Reihe an zumindest einen weiteren Zelle identisch verbunden.

4. Vorrichtung nach einem der vorhergehenden Ansprüche, **dadurch gekennzeichnet, dass** M zweite Gelenke (7) geeignet sind, der Sonnenstrahlung ausgesetzt werden, und daß die M ersten Gelenke (6) durch Mittel (9) zur Abdeckung bedeckt ist, wobei die M ersten Gelenke (6) sind nicht anzeigbar Sonnenstrahlung.

5. Vorrichtung nach einem der vorhergehenden Ansprüche, **dadurch gekennzeichnet, dass** die Mittel (1, 2, 3; 12; 23) des Grundträgers aufweisen, zumindest in Entsprechung mit den M zweiten Gelenken (7), eine antireflektierende Beschichtungsmaterials auf Strahlung mit einer Wellenlänge im Bereich von 700 Nanometer bis 300 Mikrometer.

6. Vorrichtung nach einem der vorhergehenden Ansprüche, **dadurch gekennzeichnet, daß** Mittel (1, 2, 3; 12; 23) des Grundträgers aufweisen, zumindest in Entsprechung mit den M ersten Verbindungsstellen (6), ein oder mehrere ersten Schaltungen Mikrofluidkühlung.

7. Vorrichtung nach einem der vorhergehenden Ansprüche, **dadurch gekennzeichnet, dass** die Mittel (1, 2, 3; 12; 23) der Basisträger ein Substrat (1) aus Halbleitermaterial, vorzugsweise Silizium, auf dem eine Schicht, umfassend eine oder mehrere erste Bereiche (2) thermisch leitende, vorzugsweise thermisch leitenden Streifen, von denen jeder zumindest einen Teil der Träger M ersten Verbindungsstellen (6) sowie einen oder mehrere zweite Bereiche (3) thermisch isolierenden, vorzugsweise thermisch isolierenden Streifen, jeder davon unterstützt zumindest ein Teil der M zweiten Gelenke (7), wobei eine oder mehrere erste Bereiche (2) thermisch leitende, aus einem ersten Material mit einer Wärmeleitfähigkeit von vorzugsweise nicht niedriger als 100 W / m ° K, besonders bevorzugt nicht weniger als 120 W / m ° K, noch stärker bevorzugt nicht niedriger als 150 W / m ° K, noch stärker bevorzugt nicht weniger als 200 W / m ° K, die eine oder mehrere zweite Bereiche (3) aus einem thermisch isolierendem das zweite Material mit einer thermischen Leitfähigkeit bevorzugt 10 W / m ° K, vorzugsweise nicht höher als 1 W / m ° K, besonders bevorzugt nicht größer als 0,1 W / m ° K, besonders bevorzugt nicht mehr als höchstens 0,05 W / m ° K, wobei das erste Material vorzugsweise aus Aluminiumnitrid und / oder Siliciumcarbid, wobei das zweite Material vorzugsweise aus Polyurethan-Schaumstoffen und / oder Glasfasern.

8. Vorrichtung nach Anspruch 7, wenn abhängig von Anspruch 4, **dadurch gekennzeichnet, dass** die Abdeckmittel dadurch eine oder mehrere Schutzschichten (9) auf der thermisch isolierenden M ersten Verbindungsstellen (6) positioniert ist, wobei eine oder mehrere Schutzschichten (9) Es ist bevorzugt aus einem wärmeisolierenden dem if-Wohnung Material.

9. Vorrichtung nach einem der Ansprüche 1 bis 6, **da-** **durch gekennzeichnet, daß** Mittel (1, 2, 3; 12; 23) der Basisträger eine flexible Folie (12) aus Kunststoffmaterial, vorzugsweise aus der Gruppe umfassend Polyvinylchlorid (ausgewählte umfassen PVC), Polyethylenterephthalat (PET), Polycarbonat (PC) und Polymethylmethacrylat (PMMA), um eine gerade Anzahl von Mikroröhren (11 gewickelt), die jeweils mit mindestens einer ebenen Fläche (15) der Träger, wobei die Mikroröhren (11) abwechselnd in einer ersten Konfiguration, bei dem die wenigstens eine ebene Oberfläche (15) des Trägers zu einer ersten Oberfläche des genannten mindestens einen Zelle gerichtet ist, und in einer zweiten Konfiguration, bei der die angeordneten zumindest einer ebenen Oberfläche (15) Träger wird in Richtung einer zweiten Oberfläche der genannten mindestens einen Zelle gerichtet ist, die jeweils so angeordnet Mikroröhre gemäß der ersten Konfiguration zur Unterstützung flexibler Folie (12) an mindestens einem der M ersten Verbindungsstellen (6), die jeweils so angeordnet Mikroröhre gemäß der zweiten Konfiguration unterstützt das die flexible Folie (12) an mindestens einer der M zweiten Gelenken (7), wobei die zweite Oberfläche der zumindest eine Zelle dazu ausgebildet ist, der Sonnenstrahlung ausgesetzt werden, vorzugsweise wobei es die erste Oberfläche der zumindest eine Zelle nicht in der aussetzbar Strahlungs Solar wenn die zweite Fläche des mindestens einen Zelle der Sonnenstrahlung ausgesetzt, wobei die Reaktionsgefäße (11), vorzugsweise mit einem dreieckigen Querschnitt, wobei die Vorrichtung, die vorzugsweise an der genannten ersten Oberfläche der genannten wenigstens einen Zelle eine oder mehrere zweite Schaltungen mikrofluidischen Kühl .

10. Vorrichtung nach einem der Ansprüche 1 bis 6, **dadurch gekennzeichnet, daß** Mittel (1, 2, 3; 12; 23) der Basisträger eine Mehrzahl von Formstützen (23) aus starrem Material aufweisen, vorzugsweise aus der Gruppe umfassend Silicium und Kunststoff, besonders bevorzugt aus der Gruppe bestehend aus PVC, PET, PC und PMMA, jeweils förmigen Träger (23) mit einer ebenen oberen horizontalen Element (20) und einen unteren horizontalen Flächenelements (21) von einem angeschlossenen vertikale ebene Element (22), wobei der obere horizontale ebene Element (20), zumindest eine der M zweiten Gelenken (7), wobei die untere ebenen horizontale Element (21) Stützen zumindest eines von M ersten Verbindungsstellen (6) der geformten Träger (23) einander überlappend in der Weise, daß die oberen horizontalen Flächenelemente (20) überlappen die unteren horizontalen, ebenen Elementen (21), wobei die Vielzahl von Formträgern (23) eine ebene Struktur mit einer oberen Oberfläche geeignet ist, die Strahlung ausgesetzt werden, Solar wo liegen nur M zweiten Gelenken (7), wobei die Mittel (1, 2, 3; 12; 23) des Grundgestells ebenfalls umfassend wenigstens eine Platte (24) Träger mit Anschlüssen (26) zur elektrischen Verbindung zwischen den Serien förmige Träger (23) angrenzenden überlappt sind, die geformten Träger (23) vorzugsweise vorgesehen, mechanische Mittel (27, 28) Kopplung zum Koppeln mit geformten Trägern (23) nebeneinander.

**11.** Vorrichtung nach einem der Ansprüche 1 bis 6, **dadurch gekennzeichnet, daß** Mittel (1, 2, 3; 12; 23) der Basisträger eine Vielzahl von Basiselementen, die jeweils eine flexible Folie (31) aus Material umfassen Kunststoff, vorzugsweise aus der Gruppe der PVC, PET, PC und PMMA, welche mindestens eine von den Trägern der ausgewählten M ersten Verbindungsstellen (6) und mindestens einer der M zweiten Gelenken (7), die flexible Folie (31) mit dem vorgesehenen unterhalb der genannten wenigstens einen zweiten Übergang (7) aus einem Träger (32) aus thermisch isolierendem, den Träger (32) derart, daß die Vielzahl von Grundelementen zusammengestapelt sind, um eine ebene Struktur zu bilden mit einer oberen Fläche angepasst förmigen der Sonnenstrahlung ausgesetzt werden, auf denen liegen nur M zweiten Gelenke (7), wobei die Mittel (1, 2, 3; 12; 23) des Grundträgers auch, die mindestens ein Blatt (33) des Trägers mit Klemmen für die vorgesehenen elektrische Reihenschaltung zwischen benachbarten Basiselementen überlappen, wobei der Träger (32) aus einem thermisch isolierenden Material mit einer Wärmeleitfähigkeit hergestellt, vorzugsweise 10 W / m ° K, vorzugsweise nicht höher als 1 W / m ° K, besonders bevorzugt nicht größer als 0,1 W / höchstens m ° K, besonders bevorzugt nicht größer als 0,05 W / m ° K, wobei das zweite Material vorzugsweise aus Polyurethan-Schaumstoffen und / oder Glasfasern, die eine erste Lage aus Ethylen-Vinyl-Acetat (EVA) bevorzugt oberhalb laminiert die Vielzahl von Basiselementen überlagert, und eine zweite Folie aus EVA-Laminat vorzugsweise unterhalb der wenigstens einen Bogen (33) des Trägers.

**12.** Vorrichtung nach einem der Ansprüche 1 bis 6, **dadurch gekennzeichnet, daß** Mittel (1, 2, 3; 12; 23) des Basisträgers einen Streifen (40) aus einem flexiblen Polymermaterial, und daß jedes M der ersten Verbindungsstellen (6) eine Nanostrukturoberfläche mit einem oder mehreren Abschnitten des periodischen Nanostruktur, von denen jeder einen jeweiligen Zeitraum im Bereich von 350 Nanometer bis 150 Mikrometer, vorzugsweise gleich der Periode eines entsprechenden Teils der periodischen Nanostruktur der Nanostrukturen Oberfläche M zweiten Gelenke (7).

**13.** Verfahren zur Herstellung einer Vorrichtung zur Erzeugung elektrischer Energie nach Anspruch 9, **dadurch gekennzeichnet, dass** es die folgenden Schritte umfasst:

A. es, ein flexibles Blatt (12) aus Kunststoffmaterial, die eine erste Anzahl N von ersten Segmenten unterstützt (4) aus einem ersten Material mit einer ersten Seebeck-Koeffizienten, und einer zweiten Zahl vorgenommen M von zweiten Segmenten (5) hergestellt sind in einem zweiten Material mit einem zweiten Seebeck-Koeffizienten, wobei $M \geq 1$ und N = M + 1, die ersten Segmente (4) und die zweiten Segmente (5) elektrisch in Reihe abwechselnd miteinander verbunden sind, für die M ersten Verbindungsstellen (6) zwischen einem ersten Segment (4) und einem zweiten Segment (5) und M zweiten Gelenken (7), der zwischen einem zweiten Segment (5) und ein erstes Segment (4), sie abwechselnd an einer ersten Fläche gebildet der flexiblen Folie (12);

B. fixieren ein erstes Ende des flexiblen Bogens (12) mit einem Element (13) zur Befestigung, um die erste Oberfläche der flexiblen Folie (12) in eine erste Richtung ausgerichtet sind;

C bewegt ein zweites Ende des flexiblen Bogens (12) in Richtung der ersten Richtung;

D. Positionieren einer ersten Mikroröhre (11), mit mindestens einer ebenen Fläche (15) des Trägers in einer solchen Weise, dass die ebene Fläche (15) zur Abstützung zu orientieren die erste Richtung aufeinander zu und drücken die erste Mikroröhre (11) gegen eine zweite Oberfläche der die flexible Folie (12) gegenüber der ersten Oberfläche;

E. Bewegen des zweiten Endes der flexiblen Folie (12) in eine zweite Richtung entgegengesetzt zu der ersten Richtung, derart, dass mindestens eine der M zweiten Verbindungsstellen (7) von der ebenen Oberfläche (15), der das erste Mikroröhrchen gelagert (11);

F. legen einen zweiten Mikroröhre (11), mit wenigstens einem oberflächen ebenen Oberflächen (15) der Träger in einer solchen Weise, dass die ebene Oberfläche (15) des Stütz Orientierung in Richtung auf die zweite Richtung und die zweite Mikroröhre (11) gegen die Push wobei die erste Oberfläche der flexiblen Folie (12);

G. Bewegen des zweiten Endes der flexiblen Folie (12) in Richtung der ersten Richtung, derart, dass zumindest eines der M ersten Verbindungs-gen (6) von der ebenen Oberfläche (15), die den zweiten Mikroröhre (11) getragen wird;

das Verfahren vorzugsweise die Schritte D bis G mit Mikroröhrchen (11), von denen jeder wenigstens eine ebene Fläche (15) des Trägers, so lange mindestens einer der M zweiten Gelenke (7) oder zumindest einer der M ersten Verbindungsstellen (6) abstützbar ist durch die ebene Oberfläche (15) zum Tragen eines weiteren Mikroröhre (11), wobei das Verfahren vorzugsweise durch eine Maschine, die ein Element (13) zur Fixierung ausgeführt geeignet ist, das erste Ende der flexiblen Bahn (12) zu fixieren, und ein Element (14) zum Bewegen, geeignet, um das zweite Ende der flexiblen Bahn (12), eine Steuereinheit der Maschine angepasst ist, um einen Betrieb des Elements (13) und Befestigungselement (14) zu steuern Handhabung.

**Revendications**

1. Dispositif pour la génération d'énergie électrique, comprenant au moins une cellule qui comprend un moyen (1, 2, 3; 12; 23) du support de base, **caractérisé en ce que** ladite au moins une cellule comprend en outre un premier nombre N de premiers segments (4) constituée d'un premier matériau ayant un premier coefficient de Seebeck, et un second nombre M de seconds segments (5) réalisé en un deuxième matériau ayant un deuxième coefficient de Seebeck, où M ≥ 1 et N = M + 1, le premiers segments (4) et les seconds segments (5) étant supportée par lesdits moyens (1, 2, 3; 12; 23) du support de base et étant reliés électriquement en série en alternance, pour lequel M premières jonctions (6), entre un premier segment (4) et un second segment (5), et M seconds joints (7), entre un second segment (5) et un premier segment (4), sont formées alternativement au-dessus desdits moyens de (1, 2, 3; 12; 23) du support de base, le premier matériau et le second matériau étant choisi dans le groupe de matériaux comprenant des matériaux électriquement conducteurs et de matériaux à semi-conducteurs électriquement, chacun desdits M deuxièmes articulations (7) présentant une nanostructure surface ayant une ou plusieurs parties de la nanostructure périodique dont chacune a une durée respective allant de 350 nanomètres à 150 micromètres.

2. Dispositif selon la revendication 1, **caractérisé en ce que** chacune desdites une ou plusieurs parties de la nanostructure périodique comprend une matrice d'éléments moulés, de sorte que la distance entre les éléments de ladite forme est la période de la nanostructure périodique respectif, lesdits éléments de forme étant de préférence choisis parmi groupe comprenant hémisphères saillie, creux semisphérique, rectangles saillie (également appelés nanowires), des évidements rectangulaires, triangles en saillie, des rainures triangulaires, face triangles (également appelés bow-tie) en saillie, rainures triangulaires face, croix saillantes, des rainures transversales, des cercles en saillie, et des rainures circulaires.

3. Dispositif selon la revendication 1 ou 2, **caractérisé en ce que** ladite au moins une cellule comprend deux plots ou bornes de la tablette (8) de contact, aux extrémités de la connexion en série de ladite N alternatif premiers segments (4) et desdits M seconds segments (5), moyennant quoi ladite au moins une cellule est connectée électriquement en série à au moins une autre cellule identique.

4. Dispositif selon l'une quelconque des revendications précédentes, **caractérisé en ce que** lesdits M deuxièmes articulations (7) sont adaptés pour être exposée au rayonnement solaire et **en ce que** lesdites M premières articulations (6) sont recouverts par un moyen (9) destiné à recouvrir, grâce à quoi ledit M premières articulations (6) ne sont pas visualisable au rayonnement solaire.

5. Dispositif selon l'une quelconque des revendications précédentes, **caractérisé en ce que** lesdits moyens (1, 2, 3; 12; 23) du support de base comprennent, au moins en correspondance avec lesdites M deuxièmes articulations (7), un revêtement matériau non réfléchissant pour un rayonnement ayant une longueur d'onde allant de 700 nanomètres à 300 micromètres.

6. Dispositif selon l'une quelconque des revendications précédentes, **caractérisé en ce que** lesdits moyens (1, 2, 3; 12; 23) du support de base comprennent, au moins en correspondance avec lesdites M premières jonctions (6), un ou plusieurs des premiers circuits de refroidissement microfluidique.

7. Dispositif selon l'une quelconque des revendications précédentes, **caractérisé en ce que** lesdits moyens (1, 2, 3; 12; 23) du support de base comprend un substrat (1) en matériau semi-conducteur, de préférence en silicium, sur lequel est une couche comprenant une ou plusieurs premières zones (2), des bandes de préférence thermiquement conductrices thermiquement conducteurs, dont chacun prend en charge au moins une partie desdits M premiers jonctions (6), et une ou plusieurs secondes zones (3) isolant thermiquement, de préférence des bandes thermiquement isolante, dont chacun prend en charge au moins une partie de ladite M deuxièmes articulations (7), lesdites une ou plusieurs premières zones (2) thermiquement conductrice, étant réalisées en un premier matériau ayant une conductivité thermique de préférence non inférieure à 100 W / m ° K , de préférence encore non inférieure à 120 W / m ° K, de préférence encore non inférieure à 150 W / m ° K, de préférence encore non inférieure à 200 W / m ° K, lesdites une ou plusieurs secondes zones (3) isolant thermiquement étant constituée d'un second matériau ayant une conductivité thermique de préférence ne dépassant pas 10 W / m ° K, de préférence encore non supérieure à 1 W / m ° K, de préférence encore pas supérieure à 0,1 W / m ° K, encore plus de préférence non supérieure à 0,05 W / m ° K, ledit premier matériau comprenant de préférence du nitrure d'aluminium et / ou de carbure de silicium voiture, ledit deuxième matériau comprenant de préférence des mousses de polyuréthanne et / ou des fibres de verre.

8. Dispositif selon la revendication 7, lorsqu'elle dépend de la revendication 4, **caractérisé en ce que** lesdits moyens de recouvrement comprennent une ou plusieurs couches protectrices (9) positionnée sur ladite isolation thermique M premières jonctions (6), lesdites une ou plusieurs couches de protection (9), il est de préférence en isolant thermiquement ladite deuxième matière.

9. Dispositif selon l'une quelconque des revendications 1 à 6, **caractérisé en ce que** lesdits moyens (1, 2, 3; 12; 23) du support de base comprend une feuille flexible (12) en matière plastique, de préférence choisi dans le groupe comprenant chlorure de polyvinyle (PVC), polyéthylène téréphtalate (PET), le polycarbonate (PC), et le polyméthacrylate de méthyle (PMMA), av-face autour d'un nombre pair de microtubes (11), ayant chacun au moins une surface plane (15) de support, lesdits microtubes (11) étant de-mouvement alternativement dans une première configuration, dans laquelle ladite au moins une surface plane (15) de support est dirigée vers une première surface de ladite au moins une cellule, et dans une deuxième configuration, dans laquelle ledit au moins un surface plane (15) de support est dirigée vers une seconde surface de ladite au moins une cellule, chaque microtube disposés selon ladite première configuration à supporter la feuille flexible (12) au niveau d'au moins l'une desdites M premières jonctions (6), chaque microtube agencées en fonction de ladite seconde configuration de supporter la feuille flexible (12) au niveau d'au moins l'un desdits M deuxièmes articulations (7), ladite seconde surface de ladite au moins une cellule étant adaptée pour être exposée au rayonnement solaire, ledit préférence première surface de ladite au moins une cellule non étant pouvant être exposée au rayonnement solaire, lorsque ladite seconde surface de ladite au moins une cellule est exposée à un rayonnement solaire, ledit microtubes (11) ayant de préférence une section transversale triangulaire, le dispositif comprenant de préférence au niveau de ladite première surface de ladite au moins une cellule un ou plusieurs circuits de refroidissement deuxième microfluidique.

10. Dispositif selon l'une quelconque des revendications 1 à 6, **caractérisé en ce que** lesdits moyens (1, 2, 3; 12; 23) du support de base comprennent une pluralité de supports en forme (23) de matériau rigide, de préférence choisi parmi le groupe comprenant des matériaux de silicone et les matières plastiques, et plus de préférence dans le groupe comprenant le PVC, PET, PC, et PMMA, chaque support en forme (23) ayant une partie supérieure (20) et un plan horizontal inférieur élément horizontal de l'élément plan (21) reliée par un élément plan vertical (22), ledit élément supérieur horizontal plat (20) supportant au moins l'un desdits M deuxièmes articulations (7), ledit élément plan horizontal inférieur (21) supportant au moins l'une desdites M premières jonctions (6), le des supports en forme de chevauchement (23) étant entre eux de telle sorte que lesdits éléments plans (20) se chevauchent les éléments plans horizontale supérieure inférieures horizontales (21), grâce à quoi ladite pluralité de supports en forme (23) forment une structure plane ayant une surface supérieure adaptée pour être exposée au rayonnement solaire qui se trouvent sur seulement ladite seconde M jonctions (7), lesdits moyens (1, 2, 3; 12; 23) du support de base comprenant en outre au moins une plaque (24) support munie de bornes (26) pour connexion électrique entre la série en forme de supports (23) adjacents qui se chevauchent, lesdits supports en forme (23) étant de préférence muni de moyens mécaniques (27, 28) pour couplage pour coupler avec des supports profilés (23) adjacents.

11. Dispositif selon l'une quelconque des revendications 1 à 6, **caractérisé en ce que** lesdits moyens (1, 2, 3; 12; 23) du support de base comprennent une pluralité d'éléments de base comprenant chacun une feuille souple (31) de matériau matière plastique, de préférence choisi dans le groupe comprenant le PVC, PET, PC, et PMMA, qui prend en charge au moins l'une desdites M premières jonctions (6) et au moins l'un desdits M deuxièmes articulations (7), la feuille flexible (31) étant prévu pour la au-dessous de ladite au moins une seconde jonction (7) d'un support (32) d'isolation thermique, le support (32) étant conformée de telle sorte que ladite pluralité d'éléments de base sont empilés ensemble pour former une structure plane ayant une surface supérieure adaptée pour être exposés au rayonnement solaire sur laquelle sont seuls lesdits seconds joints M (7), lesdits moyens (1, 2, 3; 12; 23) du support de base comprenant en outre au moins une feuille (33) de support munie de bornes pour le une connexion électrique en série entre la base adjacente des éléments se chevauchent, le support (32) étant réalisé en un matériau thermiquement isolant ayant une conductivité thermique de préférence ne dépassant pas 10 W / m ° K, de préférence encore non supérieure à 1 W / m ° K, voire plus de préférence non supérieure à 0,1 W / m ° K, de préférence encore pas pré-0,05 W / m ° K, ledit deuxième matériau comprenant de préférence des mousses de polyuréthanne et / ou des fibres de verre, une première feuille de vinyle-éthylène acétate (EVA) étant de préférence en couche sur le dessus de ladite pluralité d'éléments de base superposées et une seconde feuille de stratifié EVA étant de préférence au-dessous de ladite au moins une feuille (33) du support.

**12.** Dispositif selon l'une quelconque des revendications 1 à 6, **caractérisé en ce que** lesdits moyens (1, 2, 3; 12; 23) du support de base comprennent une bande (40) de matière polymère flexible, et **en ce que** chaque M desdits premiers jonctions (6) présente une surface de nanostructure comportant une ou plusieurs parties de la nanostructure périodique dont chacun dispose d'un délai respectif comprise entre 350 nanomètres et 150 micromètres, de préférence identiques à la durée d'une partie correspondante de la nanostructure périodique de la surface de nanostructures de lesdits seconds joints M (7).

**13.** Procédé de fabrication d'un dispositif pour génération d'énergie électrique selon la revendication 9, **caractérisé en ce qu'**il comprend les étapes suivantes:

A. de disposer d'une feuille flexible (12) de matière plastique qui supporte un premier nombre N de premiers segments (4) constituée d'un premier matériau ayant un premier coefficient de Seebeck, et un second nombre M de seconds segments (5) en dans un deuxième matériau ayant un deuxième coefficient de Seebeck, où M ≥ 1 et N = M + 1, les premiers segments (4) et les seconds segments (5) étant reliés électriquement en série en alternance, pour lesquels M premières jonctions (6), entre un premier segment (4) et un second segment (5), et M seconds joints (7), entre un second segment (5) et un premier segment (4), elles sont formées en alternance sur une première surface de la feuille flexible (12);

B. fixer une première extrémité de la feuille flexible (12) avec un élément (13) de fixation de façon à avoir ladite première surface de la feuille flexible (12) orienté vers une première direction;

C. déplacer une deuxième extrémité de la feuille flexible (12) en direction de ladite première direction;

D. positionner un premier microtube (11), ayant au moins une surface plane (15) de support, de manière à orienter la surface plane (15) pour supporter ladite première direction et pousser le premier microtube (11) à l'encontre une deuxième surface de la feuille flexible (12) opposée à la première surface;

E. déplacer ladite deuxième extrémité de la feuille flexible (12) vers une seconde direction opposée à ladite première direction, de telle sorte qu 'au moins l'un desdits M deuxièmes jonctions (7) est supporté par la surface sur le même plan (15) supportant le premier microtube (11);

F. placer un second microtube (11), ayant au moins une des surfaces de la surface plane (15) du support, de manière à orienter la surface plane (15) de support en direction de ladite seconde direction et pour pousser le second microtube (11) à l'encontre ladite première surface de la feuille flexible (12);

G. déplacer ladite deuxième extrémité de la feuille flexible (12) en direction de ladite première direction, de telle sorte qu'au moins l'un desdits premiers M jonctions (6) est supporté par la surface plane (15) supportant le second microtube (11);

la procédure de répéter de préférence les étapes D à G avec (11), ayant chacun au moins une surface supplémentaire microtubes plane (15) de support, à condition que au moins l'un desdits M deuxièmes articulations (7) ou au moins l'une desdites M premières jonctions (6) est supportée par la surface plane (15) pour supporter un autre microtube (11), le procédé étant de plus de préférence exécutée par une machine comprenant un élément (13) de fixation adapté pour fixer ladite première extrémité de la feuille flexible (12), et un élément (14) de déplacement, apte à déplacer ladite deuxième extrémité de la feuille flexible (12), une unité de commande de la machine étant adaptée pour commander une opération de l'élément (13) de fixation et de l'élément (14) destiné à déplacer.

**Fig.1**

Fig.2a

Fig.2b

*Fig.3*

**Fig.4a**

**Fig.4b**

EP 2 700 109 B1

Fig. 5a

nanostructures
(plasmonic lenses)

Sheet with materials previously
deposited through screen printing

14
13

Fig. 5b

clamping

Fig. 5c

"HOT" microtube
positioning

15
11
13
14

Fig. 5d

13
14
winding

Fig. 5e

11
"COLD" microtube
positioning
15
13
14

Fig. 5f

winding

Fig. 5g

Fig.6a
Fig.6b
Fig.6c

**Fig. 6d**

Support plate

24

contact prolongation

26

23

8

Support plate (plan view) Contact scheme

**Fig. 6e**

8

26

out in    out in    in out

out in

out    in out

out in    in out

in    in

out    out

microfluidic circulation scheme

**Fig. 6f**

30

out  in

plate with internal chamber

**Fig. 6g**

**_Fig.7d_**

**_Fig.7a_**

7

32

31

33

insulator

insulator

34

EVA

EVA

exchanger fluid

**_Fig.7b_**

**_Fig.7c_**

Fig.7g

Fig.7f

Fig.7e

Fig.8a

Fig.8b

**Fig.8c**

**Fig.8d**

## _Fig.9a_

Solar panel

Boiler

41  40  
42  44

## _Fig.9b_

40  41  42

Collectors made as tube bundles

EP 2 700 109 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1180802 A2
- WO 2005114748 A2
- WO 2008012516 A2
- WO 2010123735 A1
- US 20050247337 A

### Non-patent literature cited in the description

- **RITCHIE R. H.** Plasma Losses by Fast Electrons in Thin Films. *Physical Review,* June 1957, vol. 106 (5), 874-881
- Surface Plasmon Subwavelength Optics. **BARNES W.L. et al.** Nature: Insight Review Articles. Nature Publishing Group, 14 August 2003, vol. 424, 824-830